# EUROPÄISCHE PATENTANMELDUNG

(11) **EP 0 639 902 A1**
(43) Veröffentlichungstag der Anmeldung: **22.02.1995**
(21) Anmeldenummer: 94111122.1
(22) Anmeldetag: 18.07.1994
(51) Int. Cl.: H04H 1/04, H03H 7/48, H01P 5/18

(54) **Einrichtung für eine Antennenanlage zum Verteilen eines Satellitenempfangssignals**

(30) Priorität: 16.08.1993 DE 4327117
(71) Anmelder: SPAUN-electronic GmbH, D-78224 Singen (DE)
(72) Erfinder: Spaun,Friedrich, D-78244 Singen (DE); Fischer,Stephan, D-78239 Rielasingen-Worblingen (DE)
(74) Vertreter: Patentanwälte Westphal, Buchner, Mussgnug Neunert, Göhring

(57) **Zusammenfassung**

Die Einrichtung weist zur Verteilung eines Satellitenempfangssignales an eine vorgegebene Anzahl von Teilnehmeranschlüssen eine Serienschaltung von der vorgegebenen Anzahl entsprechenden Streifenleitungsrichtkopplern auf. Um an jedem Teilnehmeranschluß eine gleich hohe HF-Spannung bereitzustellen, sind die einzelnen Streifenleitungsrichtkoppler mit zunehmendem Abstand zum ersten Streifenleitungsrichtkoppler, an dem das Satellitenempfangssignal einspeisbar ist, mit einem höheren Koppelfaktor versehen.
Vorteil: Geringe Verluste, gute Entkopplung zum Teilnehmer, linearer Frequenzgang, kostengünstig herstellbar, geringer Platzbedarf.

## Beschreibung

Die Erfindung betrifft eine Einrichtung für eine Antennenanlage zum Verteilen eines Satellitenempfangssignales an eine vorgegebene Anzahl von Teilnehmeranschlüssen unter Verwendung von Verteilerelementen mit Ein- und Ausgängen.

Im Zuge der rasanten Zunahme von Satelliten zur Fernseh- und/oder Rundfunkübertragung besteht ein zunehmender Bedarf an geeigneten Verteilernetzen, um die von einer Satellitenantenne empfangenen Satellitensignale einer Vielzahl von Teilnehmern zur Verfügung zu stellen. Die von der Satellitenantenne empfangenen Funksignale hierfür liegen in einem Frequenzbereich von etwa 950 - 2500 MHz.

Eine Möglichkeit, die empfangenen Satellitensignale an mehrere Teilnehmeranschlüsse zu verteilen, besteht darin, das empfangene Satellitensignal kanalselektiv aufzubereiten und in tiefere, sogenannte terrestrische Frequenzbereiche (47 - 862 MHz) umzusetzen. Der wesentliche Vorteil dieses Verfahrens liegt darin, daß die vorhandenen Verteilernetze in Gemeinschaftsantennenanlagen, die noch nicht für Frequenzbereiche von Satellitensignalen ausgelegt sind, genutzt werden können. Darüber hinaus können durch diese Frequenzumsetzung auch nicht mit Satellitentunern ausgestattete Empfangseinrichtungen zur Weiterverarbeitung der über Satelliten übertragenen Information verwendet werden. Nachteilig einer solchen kanalselektiven Aufbereitung und Umsetzung ist der damit verbundene hohe technische Aufwand, durch den auch die Programmanzahl für die Teilnehmer beschränkt ist. Trotz des hohen technischen Aufwandes werden die übertragenen TV-Programme in eingeschränkter Qualität und Anzahl angeboten, wobei ein Stereoempfang kaum möglich ist. Eine Darbietung von über Satellit empfangenen Rundfunksendungen ist in der Regel überhaupt nicht möglich. Diese bekannten Systeme sind zudem aufgrund des hohen technischen Aufwands gegen Störungen anfällig.

Eine die oben beschriebene Frequenzumsetzung in tiefere Frequenzen umgehende Möglichkeit zur Verteilung von Satellitenempfangssignalen in Antennenanlagen besteht in der Verwendung von Verteilerelementen mit Ferritkern oder von sogenannten Wilkinson-Verteilern. Bei den Verteilern mit Ferritkern wird im wesentlichen mittels einzelner Drahtwicklungen die HF-Spannung induktiv verteilt. Obwohl diese Wilkinson-Verteiler und Ferritkern-Verteiler eine gute Entkopplung der Teilnehmer untereinander ermöglichen, ist damit nur eine Verteilung des Satellitenempfangssignales auf eine beschränkte Teilnehmeranzahl (in der Regel < 10) möglich. Als weiteren Nachteil hat sich der verhältnismäßig große Platzbedarf erwiesen, den diese bekannten Verteiler benötigen.

Um die mögliche Anzahl von Teilnehmeranschlüssen zu erhöhen, ist mittlerweile bereits versucht worden, integrierte Verstärker zwischen die einzelnen Verteilerelemente einzubauen, um dadurch die Durchgangsdämpfung der einzelnen Verteilerelemente zu kompensieren. Als integrierte Verstärker werden hierfür Breitbandverstärker für einen Frequenzbereich von 47 - 2050 MHz eingesetzt. Der Einbau von solchen Breitbandverstärkern zwischen den einzelnen Verteilerelementen brachte jedoch Intermodulationsprobleme und folglich eine geringere HF-Leistung an den Teilnehmeranschlüssen mit sich. Darüber hinaus zeigte diese Lösung kein konstantes Impedanzverhalten.

Aus DE 27 01 819 ist zwar bereits eine HF-Signalverteilanordnung für eine Fernseh-Gemeinschaftsantennenanlage bekannt. Die Verteilanorndung besteht im wesentlichen aus einer Reihenschaltung von Streifenleitungsrichtkopplern mit einem eingangsseitig angeordneten Dämpfungsfilter. Die in Serie geschalteten Streifenleitungsrichtkoppler weisen jeweils einen Koppelfaktor auf, der mit zunehmender Durchgangsdämpfung des jeweiligen Streifenleitungsrichtkopplers vergrößert ist. Dies wird durch eine mäanderförmige Gestaltung der einzelnen Streifenleitungsrichtkoppler erreicht, welche zur Erhöhung des Koppelfaktors immer länger ausgebildet sind. Durch die Längenänderung der einzelnen Streifenleitungsrichtkoppler ergibt sich jedoch eine Frequenzverschiebung der ausgekoppelten Signale und andererseits eine verhältnismäßig hohe Durchgangsdämpfung. Zudem beansprucht die Änderung des Koppelfaktors der einzelnen Streifenleitungsrichtkoppler einen großen Platz. Darüber hinaus ist die bekannte Schaltungsanordnung durch die unterschiedlichen Längen der einzelnen Streifenleitungsrichtkoppler unsymmetrisch, was sich bei der Verarbeitung von Hochfrequenzsignalen ebenfalls ungünstig auswirkt. Schließlich ist die in DE 27 01 819 vorgestellte HF-Signalverteilanordnung nicht für das Verteilen von Satellitenempfangssignalen im Frequenzbereich von etwa 800 MHz bis 2000 MHz geeignet.

Der vorliegenden Erfindung liegt deshalb die Aufgabe zugrunde, eine Einrichtung für eine Antennenanlage zum Verteilen eines Satellitenempfangssignales an eine Vielzahl von Teilnehmeranschlüssen anzugeben, die besonders einfach herzustellen ist, einen geringen Platzbedarf benötigt und eine optimale Entkopplung der Teilnehmeranschlüsse untereinander aufweist.

Diese Aufgabe wird bei der eingangs genannten Einrichtung für eine Antennenanlage durch die Merkmale des Anspruchs 1 gelöst.

Weiterbildungen der Erfindung sind Gegenstand der Unteransprüche.

Die Erfindung beruht also im wesentlichen darauf, als Verteilerelemente entsprechend der vorgegebenen Anzahl von Teilnehmeranschlüssen Streifenleitungsrichtkoppler vorzusehen, diese hintereinander zu schalten und den Kopplungsfaktor der einzelnen Streifenleitungsrichtkoppler durch eine Abstandsänderung zwischen den beiden Leitungen eines Streifenleitungsrichtkopplers zu variieren. Jeder Streifenleitungsrichtkoppler ist mit einem Eingangstor und ersten und zweiten Ausgangstoren versehen. Das Eingangstor des ersten Streifenleitungsrichtkopplers ist zum Anlegen des zu verteilenden Satellitenempfangssignals, also des direkt von der Satellitenantenne stammenden, ggf. verstärkten HF-Signales, vorgesehen und das erste Ausgangstor eines letzten Streifenleitungsrichtkopplers ist mit einem Abschlußwiderstand an Bezugspotential geschaltet. Darüber hinaus sind die ersten Ausgangstore der übrigen Streifenleitungsrichtkoppler an die Eingangstore des jeweils nächstfolgenden Streifenleitungsrichtkopplers geschaltet, während die zu versorgenden Teilnehmeranschlüsse der Gemeinschafts-Antennenanlage jeweils an eines der zweiten Ausgangstore des Streifenleitungsrichtkopplers anzuschließen ist.

Das Prinzip der Auskopplung des Satellitenempfangssignales über solche Streifenleitungsrichtkoppler, die zweckmäßigerweise als gedruckte Leiterbahnen auf Leiterplattenanordnungen ausgebildet sind, weist folgende Vorteile gegenüber der Auskopplung mit Kernmaterial, also mittels Ferritverteilern, auf:
- Geringere Verluste,
- eine konstante Impedanz Z,
- eine sehr gute Entkopplung der Teilnehmeranschlüsse untereinander,
- eine hohe Unterdrückung von Störungen, die vom einzelnen Teilnehmer in das Verteilsystem gelangen können, bedingt durch die Richtwirkung des Streifenleitungsrichtkopplers (um mindestens 10 dB besser),
- eine kostengünstige Herstellung im Vergleich zu den herkömmlichen Verteilern mit Kernmaterial oder Bewicklung.

Gegenüber der HF-Signalverteilanordnung aus DE 27 01 819 A1, weisen die Streifenleitungsrichtkoppler gemäß der Erfindung folgende Vorteile auf:
- geringerer Platzbedarf,
- keine oder nur geringe Frequenzverschiebung des ausgekoppelten Signales,
- geringe Durchgangsdämpfung,
- symmetrischer Aufbau.

Erfindungsgemäß wird für jeden Teilnehmeranschluß und damit für jeden Streifenleitungsrichtkoppler ein eigender Koppelfaktor festgelegt, wodurch die interne Durchgangsdämpfung der Serienschaltung von Streifenleitungsrichtkopplern kompensiert werden kann. Damit erhält jeder Teilnehmeranschluß exakt die gleiche HF-Spannung.

Die Streifenleitungsrichtkoppler werden zweckmäßigerweise als auf einer Seite einer Leiterplattenanordnung angeordnete und über ihre Schmalseiten gekoppelte Leiterbahnen ausgebildet. Zur Erzielung eines pro Streifenleitungsrichtkoppler zunehmenden Kopplungsfaktors wird der Abstand der Schmalseiten der gegenseitig gekoppelten Leiterbahnen pro Streifenleitungsrichtkoppler verringert. Das heißt, daß die über ihre Schmalseiten gekoppelten Leiterbahnen des eingangsseitigen Streifenleitungsrichtkopplers, an dem also das Satellitenempfangssignal von der Satellitenantenne bzw. einem der Satellitenantenne nachgeschalteten Verstärker zugeführt wird, einen größeren Abstand voneinander aufweisen, als die nachgeordneten Streifenleitungsrichtkoppler. Den geringsten Abstand voneinander weisen die über ihre Schmalseiten gekoppelten Leiterbahnen des letzten Streifenleitungsrichtkopplers auf, da dort die Durchgangsdämpfung am größten ist. Unter Zugrundelegung der Durchgangsdämpfung eines Streifenleitungsrichtkopplers ist der vorzusehende Abstand pro Streifenleitungsrichtkoppler rechnergestützt in einfacher Weise so bestimmbar, daß an den einzelnen Abgriffen der Streifenleitungsrichtkoppler eine gleichgroße HF-Spannung anliegt und somit die einzelnen Teilnehmeranschlüsse eine gleich hohe HF-Spannung als Satellitenempfangssignal erhalten.

Um einen möglichst platzsparenden Aufbau der Einrichtung zu ermöglichen, sind in einer bevorzugten Weiterbildung die einzelnen Streifenleitungsrichtkoppler mäanderförmig oder auch spiralförmig auf der Leiterplattenanordnung aufgebaut. Eine Weiterbildung der Erfindung sieht darüber hinaus vor, die parallel zueinander verlaufenden Streifenleiter der Streifenleitungsrichtkoppler mit einer linearen Koppelstrecke zu versehen. Es ist jedoch auch möglich, die Koppelstrecke der Streifenleiter sägezahnförmig zu gestalten. Solche auch als "Sägezahnrichtkoppler" bezeichneten Streifenleitungsrichtkoppler zeichnen sich durch eine geringe Durchgangsdämpfung, eine geringere Schräglage und eine bessere Richtwirkung bei konstant gleichmäßiger Auskopplung aus.

Eine vorteilhafte Ausgestaltung der Erfindung sieht vor, daß die Leiterbahnen der Streifenleitungsrichtkoppler einen Wellenwiderstand von 75 Ohm aufweisen und die offenen Tore der einzelnen Streifenleitungsrichtkoppler mit einem 75 Ohm-Widerstand abgeschlossen sind. Hierdurch wird eine konstante Impedanz des Verteilersystems von 75 Ohm gewährleistet.

Um eine möglichst hohe Anzahl von Satellitenkanälen innerhalb eines vorgegebenen Frequenzbereiches zu übertragen, sind die heutzutage ausgestrahlten Satellitensignale der nebeneinanderliegenden Kanäle abwechselnd vertikal und horizontal polarisiert. Eine Weiterbildung der erfindungsgemäßen Einrichtung sieht deshalb eine erste Serienschaltung von Streifenleitungsrichtkopplern zum Verteilen des vertikal polarisierten Satellitenempfangssignales und eine zweite Serienschaltung von Streifenleitungsrichtkopplern zum Verteilen des horizontal polarisierten Satellitenempfangssignales vor. Zusätzlich ist eine Schalteinrichtung vorgesehen, die über die Teilnehmeranschlüsse so steuerbar ist, daß entweder das horizontal polarisierte oder vertikal polarisierte Satellitenempfangssignal an den jeweiligen Teilnehmeranschluß zugeführt wird.

Eine zweckmäßige Ausgestaltung der erfindungsgemäßen Einrichtung besteht in deren modularen Aufbau, wobei die einzelnen Module zueinander kaskadierbar sind. Hierdurch ist die Anzahl der zu versorgenden Teilnehmer beliebig erweiterbar. Zu diesem Zweck sind die im Falle von vertikal und horizontal polarisierten Satellitenempfangssignalen vorgesehenen beiden Serienschaltungen von Streifenleitungsrichtkopplern samt zugehörender Schalteinrichtung auf einer einzelnen Leiterplattenanordnung angeordnet. Es hat sich als zweckmäßig herausgestellt, eine Serienschaltung von vier bzw. sechs Streifenleitungsrichtkopplern vorzusehen und diese ohne HF-Verstärkereinrichtungen in einem vorzugsweise abgeschirmten Gehäuse unterzubringen.

Zur elektrischen Verstärkung der Satellitenempfangssignale wird zweckmäßigerweise zwischen die Satellitenempfangzantenne und den ersten Streifenleitungsrichtkoppler eine HF-Verstärkereinrichtung in einem gesonderten Gehäuse hinzugeschaltet.

Eine Ausgestaltung der erfindungsgemäßen Einrichtung sieht zusätzlich eine Verstärkereinrichtung vor, die mit einer herkömmlichen Antennenanlage zum Empfang von terrestrischen Funksignalen verbunden ist. Die terrestrischen Funksignale werden in dieser Verstärkereinrichtung verstärkt und über eine Verteileranordnung sowohl den horizontal polarisierten Satellitenempfangssignalen als auch den vertikal polarisierten Satellitenempfangssignalen hinzu addiert. Durch deren unterschiedliche Frequenzbelegung (etwa 47 - 862 MHz im Vergleich zu den Satellitenempfangssignalen 950 - 1750 MHz) deren getrennte Dekodierung in Empfangsanlagen ohne weiteres mittels Bandfilter möglich. Durch diese Weiterbildung der erfindungsgemäßen Einrichtung sind die terrestrischen Funksignale auch an den einzelnen Teilnehmeranschlüssen abgreifbar. Erfindungsgemäß ist der Frequenzgang des Verstärkers für die terrestrischen Funksignale so gewählt, daß dieser für niedrige Frequenzen eine höhere Verstärkung und damit geringere Dämpfung und für höhere Frequenzen eine geringere Verstärkung und damit höhere Dämpfung aufweist.

Da der Frequenzgang und damit die Auskoppeldämpfung des Streifenleitungsrichtkopplers naturgemäß entgegengesetzt zu dem so gewählten Frequenzgang der Verstärkereinrichtung ist, d. h. für niedrige Frequenzen eine höhere Dämpfung und für höhere Frequenzen eine geringere Dämpfung aufweist, ergibt sich resultierend ein kompensierter Frequenzgang über den gesamten Frequenzbereich der erfindungsgemäßen Einrichtung.

Eine vorteilhafte Ausgestaltung der erfindungsgemäßen Einrichtung sieht vor, daß sowohl die die Satellitenempfangssignale als auch die terrestrischen Funksignale verstärkende Einrichtung in einem vorzugsweise abschirmenden Gehäuse und die Serienschaltung von Streifenleitungsrichtkopplern samt Umschalteinrichtung ebenfalls in einem eigenen, vorzugsweise abschirmenden Gehäuse untergebracht und über HF-Verbindungen zusammengeschaltet sind. Zur Erzielung eines hohen Masses an Flexibilität im Hinblick auf die zu versorgende Anzahl von Teilnehmeranschlüssen, werden über geeignete Leitungen kaskadierbare Module mit Serienschaltungen von Streifenleitungsrichtskopplern vorgesehen. Falls eine Signalverstärkung zwischen den einzelnen Modulen der Serienschaltungen von Streifenleitungsrichtkopplern notwendig sein sollte, ist eine geeignete Verstärkereinrichtung zwischen diese Module zu schalten. Die hierfür notwendige Verstärkereinrichtung ist wiederum in einem eigenen, vorzugsweise abschirmenden Gehäuse untergebracht.

Die Erfindung wird im folgenden anhand eines konkreten Ausführungsbeispiels im Zusammenhang mit insgesamt neun Figuren näher erläutert. Es zeigen:
- Fig. 1:: Eine Darstellung einer Gemeinschaftsantennenanlage mit einer erfindungsgemäßen Einrichtung einer Serienschaltung von Streifenleitungsrichtkopplern zum Verteilen von Satellitenempfangssignalen und terrestrischen Funksignalen,
- Fig. 2:: eine Verstärkereinrichtung für eine Antennenanlage nach Fig. 1 im Blockschaltbild,
- Fig. 3a:: ein Ausführungsbeispiel einer erfindungsgemäßen Serienschaltung von lineare Koppelstrecken aufweisenden Streifenleitungsrichtkopplern in einer Antennenanlage nach Fig. 1,
- Fig. 3b:: ein Ausführungsbeispiel einer erfindungsgemäßen Serienschaltung von sägezahnförmigen Koppelstrecken aufweisenden Streifenleitungsrichtkopplern in einer Antennenanlage nach Fig. 1.
- Fig. 4:: ein detailliertes Schaltbild einer erfindungsgemäßen Serienschaltung von Streifenleitungsrichtkopplern mit zugeordneten Umschalteinrichtungen,
- Fig. 5:: ein Beispiel einer Metallisierung einer Leiterplattenanordnung für eine Schaltungsanordnung nach Fig. 4,
- Fig. 6:: ein Diagramm, das die Auskoppeldämpfung der erfindungsgemäßen Streifenleitungsrichtkoppler in Abhängigkeit der Frequenz schematisch darstellt,
- Fig. 7:: ein Diagramm, das die Durchgangsdämpfung der Streifenleitungsrichtkoppler, die Auskoppeldämpfung und eine resultierende Dämpfung an einem Teilnehmeranschluß schematisch darstellt, und
- Fig. 8:: ein Diagramm des Frequenzganges der erfindungsgemässen Verstärkereinrichtung, der Auskoppeldämpfung des Streifenleitungsrichtkopplers sowie des resultierenden, kompensierten Frequenzganges an einem Teilnehmeranschluß in schematischer Form.

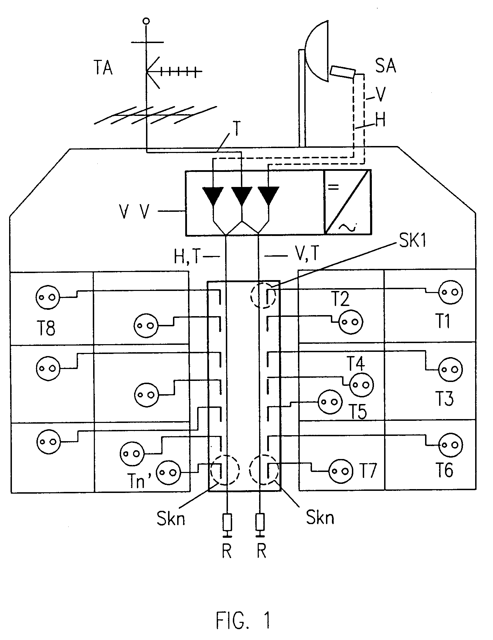

In der Beschreibung der folgenden Figuren 1 bis 8 werden für gleiche Teile stets gleiche Bezugszeichen verwendet.

Fig. 1 zeigt ein Blockschaltbild einer Antennenanlage mit einer Satellitenantennen SA zum Bereitstellen von Satellitenempfangssignalen H, V sowie einer terrestrischen Antennenanordnung TA zum Empfangen von terrestrischen Funksignalen T. Mit V sind diejenigen Satellitenempfangssignale bezeichnet, die von vertikal polarisierten Satellitenfunkwellen stammen und mit H diejenigen Satellitenempfangssignale, die von horizontal polarisierten Satellitenfunksignalen stammen. Der Einfachheit halber wird im folgenden von vertikal polarisierten Satellitenempfangssignalen V und horizontal polarisierten Satellitenempfangssignalen H gesprochen. In diesem Zusammenhang ist anzumerken, daß die in Fig. 1 dargestellte Antennenanordnung TA zum Empfang von terrestrischen Funksignalen nicht notwendigerweise vorhanden sein muß. Darüber hinaus ist die Erfindung auch nicht darauf beschränkt, vertikal polarisierte Satellitenempfangssignale und horizontal polarisierte Satellitenempfangssignale zu verteilen. Die Erfindung richtet sich vielmehr generell darauf, irgendwelche Satellitenempfangssignale an eine Vielzahl von Teilnehmeranschlüssen zu verteilen.

Wieder bezugnehmend auf Fig. 1 werden die Signale T, V und H einer Verstärkereinrichtung VV zugeführt, in der die Signale in geeigneter Weise verstärkt und an zwei Ausgängen als Addition der Signale H und T und der Signale V und T bereitgestellt werden.

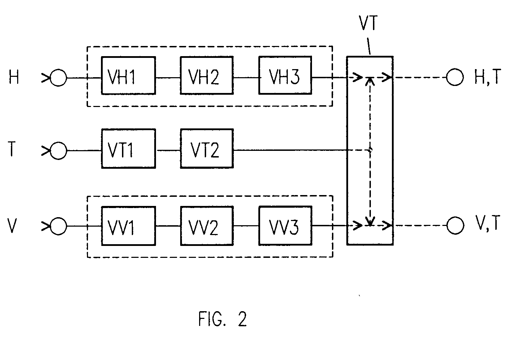

Eine mögliche Schaltungsanordnung eines derartigen Verstärkers ist in Fig. 2 als Blockschaltbild dargestellt. Die vertikal polarisierten Satellitenempfangssignale V und horizontal polarisierten Satellitenempfangssignale H gelangen jeweils über eine dreistufige Verstärkeranordnung VV1, VV2, VV3 bzw. VH1, VH2, VH3 an eine Verteileranordnung VT. Das terrestrische Funksignal T wird dagegen über eine zweistufige Verstärkeranordnung, bestehend aus den Verstärkerstufen VT1 und VT2 der Verteileranordnung VT, zugeführt. Die Verteileranordnung VT sorgt für eine Addition des terrestrischen Funksignales T mit dem horizontal polarisierten Satellitenempfangssignal H sowie zu einer Addition des terrestrischen Funksignales T mit dem vertikal polarisierten Satellitenempfangssignal V. An Ausgangklemmen der Verteileranordnung VT ist somit ein Signalgemisch der Signale V, T und der Signale H, T abgreifbar.

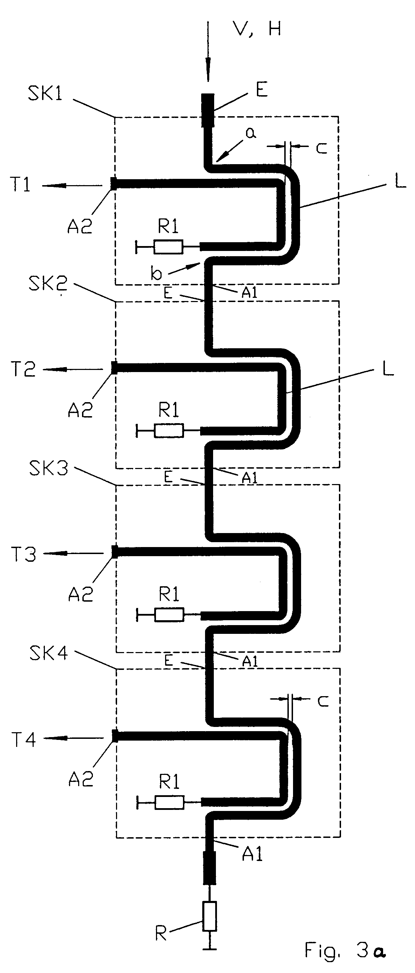

Diese beiden Signalgemische V, T sowie H, T werden in der Darstellung von Fig. 1 jeweils einer Serienschaltung von Streifenleitungsrichtkopplern SK1...SKn bzw. SK1'...SKn' zugeführt. Die von der erfindungsgemäßen Einrichtung zu versorgenden Teilnehmeranschlüsse T1 bis Tn sind jeweils mit einem der Streifenleitungsrichtkoppler SK1...SKn' in noch in Zusammenhang mit den Fig. 3a bis 5 zu erläuternder Weise verbunden. In Fig. 1 sind die der Verstärkeranordnung VV am weitesten entfernt liegenden Streifenleitungsrichtkoppler SKn, SKn' jeweils über einen Abschlußwiderstand R an Bezugspotential geschaltet.

In Fig. 3a ist eine beispielhafte Ausführung einer Serienschaltung von vier Streifenleitungsrichtkopplern SK1, SK2, SK3 und SK4 dargestellt, wie sie in einer Gemeinschaftsantennenanlage zur Versorgung von vier Teilnehmeranschlüssen T1, T2, T3 und T4 einsetzbar ist. Jeder der Streifenleitungsrichtkoppler SK1, SK2, SK3, SK4 weist ein Eingangstor E, ein erstes Ausgangstor A1 und ein zweites Ausgangstor A2 auf. Das Eingangstor E des ersten Streifenleitungsrichtkopplers SK1 ist zum Anlegen des zu verteilenden Satellitenempfangssignales V, H bzw. V, T und H, T das unmittelbar von der in Fig. 1 dargestellten Verstärkeranordnung V kommt, vorgesehen. Das erste Ausgangstor A1 des letzten Streifenleitungsrichtkopplers, hier SK4, ist mit einem Abschlußwiderstand R, vorzugsweise von 75 Ohm, an Bezugspotential geschaltet. Die ersten Ausgangstore A1 der übrigen Streifenleitungsrichtkoppler SK1, SK2, SK3 sind mit den Eingangstoren E des jeweils nächstfolgenden Streifenleitungsrichtkopplers SK2, SK3 und SK4 verbunden.

Die einzelnen Streifenleitungsrichtkoppler SK1 sind in der Darstellung von Fig. 3a als über ihre Schmalseite gekoppelt Streifenleitungen SK2, SK3, SK4 ausgebildet. Die Schmalseiten sind geradlinig und damit linear gestaltet. Die am Eingangstor E eingespeiste Energie verteilt sich auf die Ausgangstore A1 und A2, während das dem zweiten Ausgangstor A2 gegenüberliegende Ende der ausgekoppelten Streifenleitung L vom Eingangstor E völlig entkoppelt ist. Die in der angekoppelten Leitung L, also in der das zweite Ausgangstor A2 enthaltenden Leitung L, erzeugte Welle ist der vom Eingangstor E zum ersten Ausgangstor A1 fliessenden Welle entgegengesetzt. Man bezeichnet deshalb einen solchen Streifenleitungsrichtkoppler auch als Rückwärtswellenkoppler. Aus Impedanzgründen ist die angekoppelte Streifenleitung L an ihrem offenen Ende mit einem Widerstand R1, der vorzugsweise 75 Ohm aufweist, an Bezugspotential geschaltet.

Die in Fig. 3a dargestellten Streifenleitungen L der Serienschaltung von Streifenleitungsrichtkopplern SK1, SK2, SK3 und SK4 können in einfacher Weise auf einer Seite einer Leiterplattenanordnung als nebeneinander liegende Leiterbahnen realisiert werden. Aus Gründen der Verringerung der Baugröße sind die einzelnen Streifenleitungsrichtkoppler SK1 bis SK4 spiralförmig oder - wie in Fig. 3a gezeigt - mäanderförmig angeordnet. Wie in Fig. 3a zusätzlich deutlich zu erkennen ist, sind die einzelnen Streifenleitungen L der Streifenleitungsrichtkoppler SK1, SK2, SK3 und SK4, ausgehend vom eingangsseitigen Streifenleitungsrichtkoppler SK1, zunehmend näher aneinander angeordnet. D. h. daß der Abstand c der beiden Streifenleitungen L pro Streifenleitungsrichtkoppler SK1 bis SK4 zunehmend kleiner wird. Auf diese Weise ist ein vorgegebener Koppelfaktor einstellbar, wodurch die steigende Durchgangsdämpfung der Serienschaltung von Streifenleitungrichtskopplern SK1 bis SK4 kompensiert werden kann. Dadurch erhält jeder Teilnehmeranschluß T1 bis T4 in etwa die gleiche HF-Energie.

In einer konkreten Ausführungsform für ein Verteilernetz, das für einen Frequenzbereich von 47 bis 2200 MHz ausgelegt ist, weist jeder der Streifenleitungsrichtkoppler SK1 bis SK4 eine mittlere Länge von 28,25 mm auf. Diese Länge ist in Fig. 3a durch die Begrenzungspunkte a und b gekennzeichnet. Zur Kompensation der steigenden Durchgangsdämpfung der Serienschaltung von Streifenleitungsrichtkopplern SK1 bis SK4 sind die Abstände der Streifenleitungen L der einzelnen Streifenleitungsrichtkoppler SK1 bis SK4 in folgender Weise gewählt: SK1: c = 0,8 mm; SK2: c = 0,7 mm; SK3: c = 0,6 mm und SK4: c = 0,5 mm.

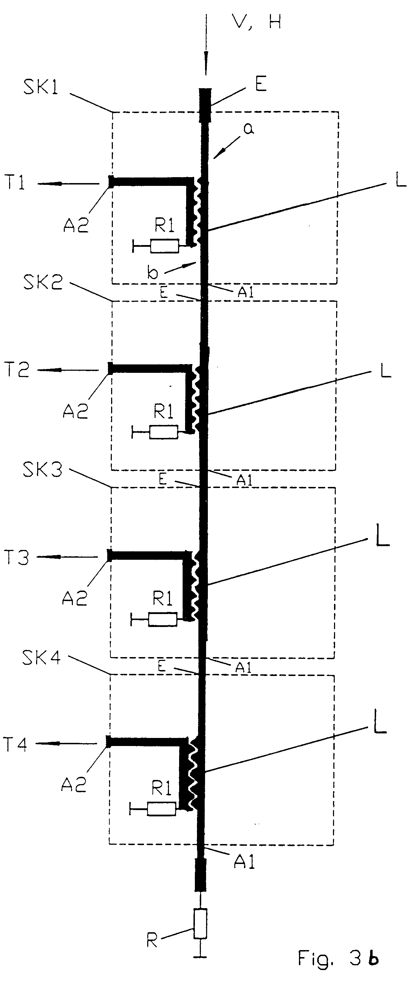

In Fig. 3b ist eine weitere Ausführungsform einer Serienschaltung von vier Streifenleitungsrichtkopplern SK1, SK2, SK3 und SK4 dargestellt, wie sie in einer Gemeinschaftsantennenanlage zur Versorgung von vier Teilnehmeranschlüssen T1, T2, T3 und T4 einsetzbar ist. Diese Ausführungsform entspricht weitgehend der in Fig. 3a dargestellten Ausführungsform, wobei die einzelnen Streifenleitungsrichtkoppler SK1, SK2, SK3 und SK4 jetzt jeweils sägezahnförmige Koppelstrecken aufweisen. Wie in Fig. 3b deutlich zu erkennen, weisen die einzelnen Streifenleitungsrichtkoppler SK1, SK2, SK3 und SK4 ausgehend vom eingangsseitigen Streifenleitungsrichtkoppler SK1 in Richtung ausgangsseitigen Streifenleitungsrichtkoppler SK4 wieder einen zunehmenden Koppelfaktor aus, was durch eine Distanzänderung zwischen den sägezahnartig gestalteten Streifenleitern L erreicht wird. Wie in Fig. 3b weiter ersichtlich, ist es mit solchen sägezahnförmig ausgestalteten Streifenleitungsrichtkopplern SK1 bis SK4 möglich, eine im Vergleich zu der Ausführungsform von Fig. 3a gleichwirkende Verteilanordnung zu schaffen, die jedoch wesentlich weniger Fläche beansprucht. Eine schleifen- oder mäanderförmige Ausbildung der sich gegenüberliegenden Streifenleiter L ist nicht notwendig, wie Fig. 3b zeigt.

Solche Sägezahnrichtkoppler zeichnen sich durch eine geringe Durchgangsdämpfung, eine geringe Schräglage, eine günstige Richtwirkung und eine konstant gleichmäßige Auskopplung aus. Die Sägezahnrichtkoppler haben darüber hinaus den Vorteil, daß der kapazitive Koppelfaktor an den induktiven Koppelfaktor angeglichen wird bzw. die Gleich- und Gegentaktgeschwindigkeiten zueinander ausgeglichen sind.

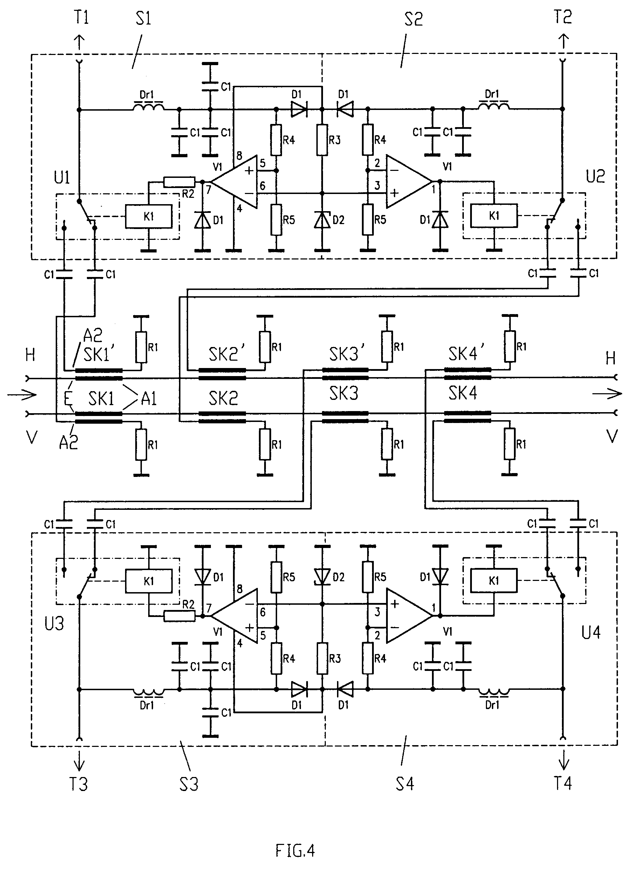

In Fig. 4 ist eine detaillierte Schaltungsanordnung dargestellt, wie diese bei einer erfindungsgemäßen Einrichtung gemäß Fig. 1 einsetzbar ist. Die in Fig. 4 gezeigte Schaltungsanordnung dient zum Verteilen von Satellitenempfangssignalen an vier Teilnehmeranschlüsse T1, T2, T3, T4. Zum Verteilen der beiden Satellitenempfangssignale H, V ist erfindungsgemäß jeweils eine eigene Serienschaltung von 4 Streifenleitungsrichtkopplern SK1, SK2, SK3, SK4 und SK1', SK2', SK3' und SK4' vorgesehen. Jeder der Teilnehmeranschlüsse T1 bis T4 ist über eine entsprechende Schalteinrichtung S1 bis S4 entweder an den jeweiligen Streifenleitungsrichtkoppler SK1 bis SK4 für das vertikal polarisierte Satellitenempfangssignal V oder an den jeweiligen Streifenleitungsrichtkoppler SK1'bis SK4' für das horizontal polarisierte Satellitenempfangssignal H schaltbar. Der Aufbau der hierfür vorgesehenen einzelnen Schalteinrichtungen S1 bis S4 ist jeweils gleich, so daß im folgenden lediglich die Schaltungsanordnung der Schalteinrichtung S1 stellvertretend beschrieben wird. Der Teilnehmeranschluß T1 ist über einen Umschalter U1 in der Schalteinrichtung S1 über Koppelkondensatoren C1 entweder an das Ausgangstor A2 des Streifenleitungsrichtkopplers SK1 oder an das Ausgangstor A2 des Streifenleitungsrichtkopplers SK1' schaltbar. Der Umschalter U1 wird dabei von einem am Teilnehmeranschluß T1 anzuschließenden Satellitenempfangsgerät durch Bereitstellen einer Steuerspannung umgeschaltet. Im vorliegenden Beispiel beträgt diese Steuerspannung beispielsweise 14 Volt, wenn am Teilnehmeranschluß T1 das vertikal polarisierte Satellitenempfangssignal V und 18 Volt, wenn das horizontal polarisierte Satellitenempfangssignal H bereit gestellt werden soll. Diese beiden Steuerspannungen werden in einer Spannungsvergleicherschaltung, bestehend aus den in Fig. 4 dargestellten Elementen Dr1, C1, D1, D2, R2, R3, R4, R5 und V1, gebildet.

Der Widerstand R3 weist einen Widerstandswert von 1 KOhm, der Widerstand R4 12 KOhm, der Widerstand R5 7,5 KOhm auf. Die Zenerdiode D2 verfügt über eine Zenerspannung von 5,6 Volt. Die an den Verbindungspunkten von Zenerdiode D2 und Widerstand R3 sowie der Widerstände R4 und R5 auftretenden Spannungen werden in einem Komparator V1 verglichen und abhängig hiervon eine Ausgangsspannung am Ausgang des Komparators V1 generiert, um den Schalter U1 umzuschalten. Im Beispiel von Fig. 4 ist der Umschalter U1 als Relaisumschalter realisiert. Es können jedoch auch beispielsweise PIN-Schalter oder beliebig andere Schalter hierfür eingesetzt werden. Durch die angegebene Dimensionierung der Widerstände R3 bis R5 und der Zenerdiode D2 befindet sich der Umschalter U1 dann in der in Fig. 4 dargestellten Stellung (Ruhestellung), wenn die Spannung am Teilnehmeranschluß T1 ungefähr kleiner als 15 Volt ist. Steigt dagegen die Steuerspannung am Teilnehmeranschluß T1 auf 18 Volt an, zieht der Relaisumschalter U1 an und verbindet den Teilnehmeranschluß T1 mit dem Ausgangstor A2 des Streifenleitungsrichtkopplers SK1', so daß am Teilnehmeranschluß T1 das horizontal polarisierte Satellitenempfangssignal H abgreifbar ist. Die übrigen Schalteinrichtungen S2 bis S4 samt Umschalter U2 bis U4 sind gleich aufgebaut und funktionnieren in ähnlicher Weise.

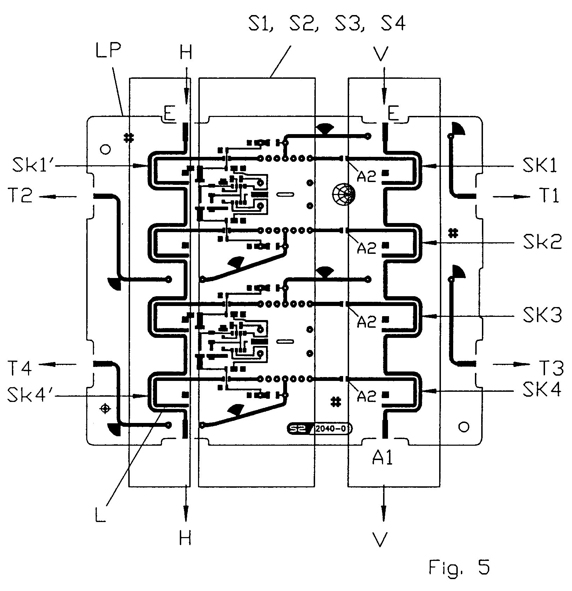

Es hat sich als zweckmäßig erwiesen, die in Fig. 4 dargestellte Schaltungsanordnung als Modul auf einer einzigen Leiterplattenanordnung zu realisieren und dieses Modul innerhalb eines vorzugsweise abschirmenden Gehäuses unterzubringen. Eine hierfür geeignete Leiterplattenanordnung ist in Fig. 5 zu sehen. Gleiche Bezugszeichen bezeichnen die bereits bekannten Teile. Die in Fig. 5 dargestellte Metallisierung der Leiterplattenanordnung für eine Schaltungsanordnung von Fig. 4 zeigt deutlich die beiden Serienschaltungen von Streifenleitungsrichtkopplern SK1 bis SK4 und SK1' bis SK4', wie diese bereits im Zusammenhang mit Fig. 3 eingehend erläutert worden ist. Zusätzlich ist die in Fig. 5 dargestellten Leiterplattenanordnung mit Leiterbahnen zur Aufnahme der Schalteinrichtungen S1, S2, S3 und S4 versehen.

An den Eingangstoren E des jeweils ersten Streifenleitungsrichtkopplers SK1 bzw. SK1' können vertikal polarisierte Satellitenempfangssignale V bzw. horizontal polarisierte Satellitenempfangssignale H als auch jeweils zusätzlich - wie im Zusammenhang mit Fig. 1 bereits erläutert - terrestrische Funksignal T zugeführt werden.

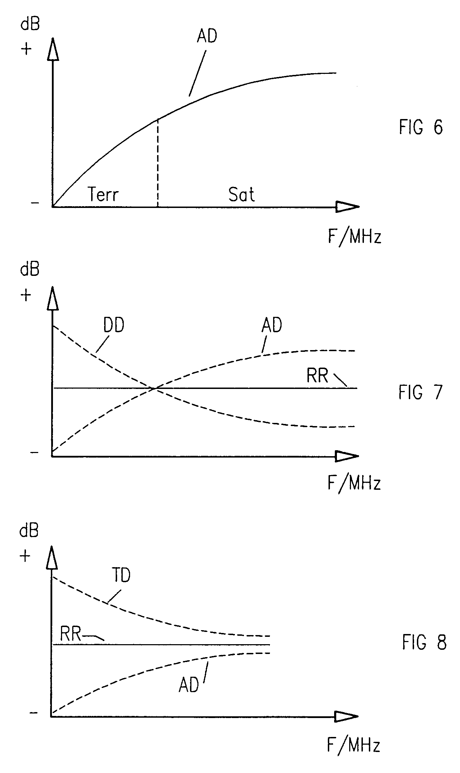

Die erfindungsgemäße Einrichtung für eine Antennenanlage zum Verteilen eines Satellitenempfangssignales bzw. terrestrischen Funksignales an eine vorgegebene Anzahl von Teilnehmeranschlüssen mit einer Serienschaltung von Streifenleitungsrichtkopplern bzw. Serienschaltungen von Streifenleitungsrichtkopplern zeichnet sich durch einen besonders guten linearen Frequenzverlauf auf. Dies wird im Zusammenhang mit den folgenden Fig. 6 bis 8 ersichtlich. In Fig. 6 ist die Auskoppeldämpfung eines Streifenleitungsrichtkopplers schematisch in Abhängigkeit der Frequenz F aufgetragen. Mit Terr ist der terrestrische Frequenzbereich und mit Sat der Frequenzbereich für Satellitenempfang bezeichnet. Die Auskoppeldämpfung des Streifenleitungsrichtkopplers steigt mit zunehmender Frequenz an, wobei die Steigung mit zunehmender Frequenz abnimmt und die Auskoppeldämpfung bei hohen Frequenzen kaum mehr zunimmt. Der Verlauf der Auskoppeldämpfung ist in Fig. 6 mit AD bezeichnet.

In Fig. 7 ist diese Auskoppeldämpfung AD zusätzlich zur Durchgangsdämpfung DD des Streifenleitungsrichtkopplers in Abhängigkeit der Frequenz F schematisch dargestellt. Der resultierende Frequenzgang RR zeigt einen besonders linearen Verlauf.

Ein besonders linearer und damit kompensierter Frequenzgang stellt sich auch im Bereich terrestrischer Frequenzen ein, wie anhand von Fig. 8 deutlich zu erkennen ist. Die Auskoppeldämpfung des Streifenleitungsrichtkopplers ist wieder mit AD bezeichnet, während der Frequenzgang des Verstärkers für die terrestrischen Funksignale, wie er im Zusammenhang mit den Figuren 1 und 2 erläutert wurde, den mit TD bezeichneten Verlauf hat. Die Frequenzgänge DD und TD gemäß den Figuren 7 und 8 mit einer höheren Verstärkung bei niedrigen Frequenzen und einer geringeren Verstärkung bei höheren Frequenzen ist durch einen möglichst gering gegengekoppelten Verstärker erreichbar. Zur Erzielung eines möglichst linearen resultierenden Frequenzganges RR wird deswegen erfindungsgemäß der Frequenzgang der Verstärkeranordnung entgegengesetzt zu dem der Auskoppeldämpfung des Streifenleitungsrichtkopplers gewählt.

Mit der erfindungsgemäßen Einrichtung ist es in einfacher Weise möglich eine Vielzahl von Teilnehmeranschlüssen mit einem Satellitenempfangssignal, das von einer einzigen Satellitenempfangsantenne stammt, zu versorgen. Es können beispielsweise 100 Teilnehmer versorgt werden. Es müssen lediglich die einzelnen zuvor erläuterten Module zueinander kaskadiert werden. Um eine etwaige notwendige Signalverstärkung zwischen den einzelnen die Streifenleitungsrichtkoppler enthaltenden Modulen zu ermöglichen, werden zwischen die Module Zwischenverstärker, die in eigenen Gehäusen untergebracht werden, geschaltet.

## Patentansprüche

1. Einrichtung für eine Antennenanlage zum Verteilen eines Satellitenempfangssignales (V; H) an eine vorgegebene Anzahl von Teilnehmeranschlüssen (T1 ... Tn) unter Verwendung von Verteilerelementen mit Ein- und Ausgängen, wobei als Verteilerelemente eine Serienschaltung von der vorgegebenen Anzahl von Teilnehmeranschlüssen (T1 ... Tn) entsprechenden Streifenleitungsrichtkopplern (SK1, SK2 ... SKn) mit jeweils einem Eingangstor (E) und ersten und zweiten Ausgangstoren (A1, A2) vorgesehen ist, das Eingangstor (E) eines ersten Streifenleitungsrichtkopplers (SK1) der Serienschaltung zum Anlegen des zu verteilenden Satellitenempfangssignales (V; H) vorgesehen ist, das erste Ausgangstor (A1) eines letzten Streifenleitungsrichtkopplers (SKn) mit einem Abschlußwiderstand (R) an ein Bezugspotential geschaltet ist, die ersten Ausgangstore (A1) der übrigen Streifenleitungsrichtkoppler (SK1 ... SKn-1) an die Eingangstore (E) des jeweils nächstfolgenden Streifenleitungsrichtkopplers (SK2 ... SKn) geschaltet sind, und die zweiten Ausgangstore (A2) der Streifenleitungsrichtkoppler (SK1 ... SKn) jeweils mit einem anderen Teilnehmeranschluß (T1 ... Tn) der Antennenanlage verbindbar sind, und wobei die in Serie geschalteten Streifenleitungsrichtkoppler (SK1 ... SKn) jeweils einen Koppelfaktor aufweisen, der mit zunehmender Durchgangsdämpfung des jeweiligen Streifenleitungsrichtkopplers (SK1 ... SKn) vergrößert ist, dadurch gekennzeichnet, daß die Streifenleitungsrichtkoppler (SK1 ... SKn) als auf einer Seite einer Leiterplattenanordnung (LP) angeordnete Leiterbahnen (L) ausgebildet und über ihre Schmalseiten gekoppelt sind, und daß zur Koppelfaktorvergrößerung, ausgehend vom eingangsseitigen Streifenleitungsrichtkoppler (SK1) zum ausgangsseitigen Streifenleitungsrichtkoppler (SKn), die mit ihren Schmalseiten nebeneinander liegenden Leiterbahnen (L) pro Streifenleitungsrichtkoppler (SK1 ... SKn) in einem zunehmend kleineren Abstand (a) nebeneinander liegen.

2. Einrichtung nach Anspruch 1, dadurch gekennzeichnet, daß die Streifenleitungsrichtkoppler (SK1 ... SKn) spiral- oder mäanderförmig ausgebildet sind.

3. Einrichtung nach Anspruch 1 oder 2, dadurch gekennzeichnet, daß die Streifenleitungsrichtkoppler (SK1 ... SKn) eine sägezahnförmige Koppelstrecke aufweisen.

4. Einrichtung nach Anspruch 1 oder 2, dadurch gekennzeichnet, daß die Streifenleitungsrichtkoppler (SK1 ... SKn) eine lineare Koppelstrecke aufweisen.

5. Einrichtung nach einem der Ansprüche 1 bis 4, dadurch gekennzeichnet, daß die Leiterbahnen (L) der Streifenleitungsrichtkoppler (SK1 ... SKn) einen Wellenwiderstand (Z) von 75 Ohm aufweisen und der Abschlußwiderstand (R) einen Widerstandswert von 75 Ohm aufweist.

6. Einrichtung nach einem der Ansprüche 1 bis 5, dadurch gekennzeichnet, daß die Antennenanlage zum Verteilen eines ersten, vertikal polarisierten Satellitenempfangssignales (V) und einem zweiten, horizontal polarisiertem Satellitenempfangssignal (H) vorgesehen ist, daß eine erste Serienschaltung von Streifenleitungsrichtkopplern (SK1 ... SK4) zum Verteilen des ersten Satellitenempfangssignales (V) und eine zweite Serienschaltung von Streifenleitungsrichtkopplern (SK1'...SK4') zum Verteilen des zweiten Satellitenempfangssignales (H) vorgesehen ist, und daß eine Schalteinrichtung (S1, S2, S3, S4) zum wahlweisen Verbinden der Anschlüsse (T1, T2, T3, T4) an das erste oder zweite Satellitenempfangssignal (V, H) vorgesehen ist.

7. Einrichtung nach Anspruch 6, dadurch gekennzeichnet, daß eine vorgegebene Anzahl der ersten und zweiten in Serie geschalteten Streifenleitungsrichtkoppler (SK1, SK1' ... SK4, SK4') samt Schalteinrichtung (S1, S2, S3, S4) auf einer Leiterplattenanordnung (LP) angeordnet und als Modul ausgebildet sind, wobei das Modul mit weiteren, analog aufgebauten Modulen kaskadierbar ist.

8. Einrichtung nach einem der Ansprüche 1 bis 7, dadurch gekennzeichnet, daß die Antennenanlage eine Verstärkereinrichtung (V) zum Verstärken der Satellitenempfangssignale (V, H) aufweist und die Verstärkereinrichtung (V2) zwischen einer Satellitenempfangsantenne (SA) und den ersten Streifenleitungsrichtkopplern (SK1, SK1') geschaltet ist,

9. Einrichtung nach Anspruch 8, dadurch gekennzeichnet, daß die Antennenanlage zusätzlich eine Antennenanordnung (TA) zum Empfangen von terrestrischen Funksignalen und eine Verstärkereinrichtung (V) zum Verstärken der terrestrischen Funksignale (T) aufweist, daß eine Verteileranordnung (VT) vorgesehen ist, um die verstärkten terrestrischen Funksignale (T) sowohl dem ersten verstärkten Satellitenempfangssignal (V) als auch dem zweiten verstärkten Satellitenempfangssignal (H) zuzuführen, wobei die Verstärkereinrichtung (V) nur gering gegengekoppelt ausgebildet ist.
